# EUROPÄISCHE PATENTANMELDUNG

(11) **EP 4 633 303 A1**
(43) Veröffentlichungstag der Anmeldung: **15.10.2025**
(21) Anmeldenummer: 25168112.8
(22) Anmeldetag: 02.04.2025
(51) Int. Cl.: H05K 7/14

(54) **FUNKTIONSMODUL ZUR AUSBILDUNG EINER DEZENTRALEN AUTOMATISIERUNGSPLATTFORM**

(30) Priorität: 12.04.2024 DE 102024110302
(71) Anmelder: Murrelektronik GmbH, 71570 Oppenweiler (DE)
(72) Erfinder: Prein, Olaf, 32676 Lügde-Rischenau (DE); Feisst, Heiko, 73278 Schlierbach (DE); Roolf, Tim, 71522 Backnang (DE)
(74) Vertreter: Bösherz Goebel Patentanwälte

(57) **Zusammenfassung**

Die Erfindung betrifft ein Funktionsmodul (200) zur Ausbildung einer dezentralen Automatisierungsplattform (1), bei welcher das Funktionsmodul (200) mit mehreren weiteren Funktionsmodulen (201) modular verbunden ist, um modular mehrere Funktionen zur Automatisierung einer industriellen Anlage bereitzustellen, aufweisend:
- eine Elektronikanordnung (60) für die Bereitstellung zumindest einer der mehreren Funktionen,
- einen Grundkörper (20) mit einem Grundkörpergehäuse (30), in welchem die Elektronikanordnung (60) angeordnet ist,
- eine Verbindungsanordnung (40), die am Grundkörpergehäuse (30) angeordnet ist und/oder mit der Elektronikanordnung (60) elektrisch verbunden ist, um einen elektrischen Anschluss für eines der mehreren weiteren Funktionsmodule (201) bereitzustellen,
wobei die Verbindungsanordnung (40) dazu ausgebildet ist, einen Hauptenergiefluss, einen Hilfsenergiefluss und einen Datenfluss zwischen dem Funktionsmodul (200) und dem angeschlossenen weiteren Funktionsmodul (201) bereitzustellen, um die Automatisierungsplattform (1) zur Automatisierung der industriellen Anlage zu betreiben.

## Beschreibung

Die vorliegende Erfindung betrifft ein Funktionsmodul zur Ausbildung einer dezentralen Automatisierungsplattform, welches modular mit mehreren weiteren Funktionsmodulen verbunden werden kann, um modular erweiterbar Funktionen zur Automatisierung einer industriellen Anlage bereitzustellen. Ferner bezieht sich die Erfindung auf die Automatisierungsplattform und ein Verfahren.

### Stand der Technik

Aus dem Stand der Technik ist es bekannt, dass modulare Automatisierungslösungen dafür genutzt werden, um in einer industriellen Anlage elektrische Geräte über Energieleitungen mit Energie zu versorgen und über Steuerungsleitungen, wie z. B. Feldbusleitungen oder IO-Link, anzusteuern. Die Modularität wird dabei oft dadurch erreicht, dass einzelne, voneinander unabhängige Funktionsmodule verwendet werden, die individuell konfiguriert und über eine Backplane miteinander verbunden werden können. Dies hat den Vorteil, dass die Automatisierungslösungen flexibel an die jeweiligen Anforderungen der industriellen Anlage angepasst werden können und somit eine hohe Effizienz und Wirtschaftlichkeit gewährleisten.

Es ist bei herkömmlichen Lösungen häufig ein Problem, dass eine Montage von Funktionsmodulen einer Automatisierungsplattform aufwändig und fehleranfällig ist. Weiterhin können herkömmliche Automatisierungsplattformen oft nicht flexibel genug an individuelle Anforderungen angepasst werden, da die Kombination von Funktionsmodulen durch die Ausbildung der Backplane limitiert ist. Ebenfalls kann der höhere Platzbedarf bekannter Lösungen ein Problem sein.

Es ist daher eine Aufgabe der vorliegenden Erfindung, die voranstehend beschriebenen Nachteile zumindest teilweise zu beheben. Es ist insbesondere eine Aufgabe der vorliegenden Erfindung, die Kombination von Funktionsmodulen zur Ausbildung einer Automatisierungsplattform für industrielle Anlagen zu verbessern.

### Offenbarung der Erfindung

Gegenstand der Erfindung ist ein Funktionsmodul mit den Merkmalen des Anspruchs 1, eine Automatisierungsplattform mit den Merkmalen des Anspruchs 13 sowie ein Verfahren mit den Merkmalen des Anspruchs 15. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Funktionsmodul beschrieben sind, selbstverständlich auch im Zusammenhang mit der erfindungsgemäßen Automatisierungsplattform sowie dem erfindungsgemäßen Verfahren, und jeweils umgekehrt, so dass bezüglich der Offenbarung zu den einzelnen Erfindungsaspekten stets wechselseitig Bezug genommen wird bzw. werden kann.

Gegenstand der Erfindung ist insbesondere ein Funktionsmodul zur Ausbildung einer dezentralen Automatisierungsplattform.

Die Ausbildung der Automatisierungsplattform ist z. B. dadurch möglich, dass das Funktionsmodul mit weiteren Funktionsmodulen verbunden wird. Mit anderen Worten kann bei dieser Automatisierungsplattform das Funktionsmodul mit mehreren weiteren Funktionsmodulen modular verbunden werden bzw. sein. Dies ermöglicht es, modular erweiterbar mehrere Funktionen zur Automatisierung einer industriellen Anlage bereitzustellen. Es kann somit ein modularer Aufbau der Automatisierungsplattform vorgesehen sein, bei welchem gewünschte Funktionen zur Automatisierung der industriellen Anlage durch das Anschließen weiterer Funktionsmodule hinzugefügt werden können. Die Funktionen können dabei modular erweitert werden - "Modularität" der Funktionen bedeutet hier insbesondere, dass die Funktionen aus einer Auswahl von Funktionen zusammengestellt werden können, indem die entsprechenden Funktionsmodule ausgewählt und verbunden werden. Die Funktionsmodule sind entsprechend miteinander anschlusskompatibel, jedoch ggf. nicht vollständig baugleich, da abhängig von ihrer individuellen Funktion unterschiedliche Anschlusskonfigurationen vorgesehen sein können.

Das Funktionsmodul und ggf. jedes der weiteren Funktionsmodule kann optional eine Elektronikanordnung für die Bereitstellung zumindest einer der mehreren Funktionen aufweisen. Mit anderen Worten können die Funktionen zumindest teilweise durch eine Elektronik ausgeführt werden, wie bspw. eine Ansteuerung oder eine Energieversorgung von elektrischen Geräten der Anlage. Weitere beispielhafte Funktionen, die insbesondere durch das Funktionsmodul und ggf. die weiteren Funktionsmodule bereitgestellt werden können, sind nicht abschließend: die Überwachung von Prozessen, die Regelung von Temperatur, Druck oder Feuchtigkeit, die Datenerfassung und -verarbeitung, die Kommunikation mit anderen Systemen, die Sicherheitsüberwachung und -steuerung, die Fernsteuerung von Anlagen und Geräten, die Diagnose von Fehlern und Störungen und die Steuerung von Robotern.

Das Funktionsmodul und ggf. jedes der weiteren Funktionsmodule kann optional einen Grundkörper mit einem Grundkörpergehäuse aufweisen, in welchem die Elektronikanordnung angeordnet ist. Die Anordnung der Elektronikanordnung im Grundkörpergehäuse kann bei einer Herstellung z. B. dadurch erfolgen, dass die Elektronikanordnung mit ihrer Leiterplatte in das Grundkörpergehäuse eingesetzt und befestigt wird. Die Leiterplatte kann dabei mit Befestigungselementen im Grundkörpergehäuse fixiert werden, z. B. durch Schrauben oder Kleben. Eine weitere Möglichkeit ist, dass die Elektronikanordnung in einem separaten Gehäuse untergebracht wird, welches dann in das Grundkörpergehäuse eingesetzt wird.

Das Funktionsmodul und ggf. jedes der weiteren Funktionsmodule kann optional eine (insbesondere erste) Verbindungsanordnung aufweisen, die am Grundkörpergehäuse und/oder einem damit verbundenen Gehäuse angeordnet ist und/oder mit der Elektronikanordnung elektrisch verbunden ist, um einen elektrischen Anschluss für eines der mehreren weiteren Funktionsmodule bereitzustellen. Dabei kann die Verbindungsanordnung dazu ausgebildet sein, einen Hauptenergiefluss und/oder einen Hilfsenergiefluss und/oder einen Datenfluss (unmittelbar) zwischen dem Funktionsmodul und dem daran angeschlossenen weiteren Funktionsmodul (und/oder mittelbar über das angeschlossene weitere Funktionsmodul auch den weiteren Funktionsmodulen der Automatisierungsplattform) bereitzustellen. Dies ermöglicht es, dass die Automatisierungsplattform zur Automatisierung der industriellen Anlage betrieben werden kann.

Die Verbindungsanordnung kann die folgenden Verbindungselemente, insbesondere in der Form elektrischer Anschlüsse, umfassen:
- ein Hauptenergieverbindungselement zur Bereitstellung des Hauptenergieflusses für das daran angeschlossene weitere Funktionsmodul, und/oder
- ein Hilfsenergieverbindungselement zur Bereitstellung des Hilfsenergieflusses, insbesondere mit geringerer elektrischer Spannung (und/oder geringerem elektrischen Strom) als der Hauptenergiefluss, für das daran angeschlossene weitere Funktionsmodul, und/oder
- ein Datenverbindungselement zur Bereitstellung des Datenflusses für das daran angeschlossene weitere Funktionsmodul.

Das Datenverbindungselement kann z. B. zur Übertragung von Daten eines Feldbus dienen und daher als ein Feldbusanschluss ausgebildet sein. Der Feldbus ist bspw. ein industrieller Datenbus, der zur Übertragung von Daten zwischen verschiedenen Komponenten einer industriellen Anlage verwendet wird. Der Feldbus ermöglicht eine schnelle und zuverlässige Übertragung von Daten in Echtzeit. Ebenfalls ist es möglich, dass das Datenverbindungselement zur Übertragung von Daten eines IO-Link Kommunikationssystems verwendet wird. Entsprechend kann das Datenverbindungselement in der Lage sein, Daten von IO-Link fähigen Sensoren und Aktoren zu empfangen und zu übertragen. Dadurch wird eine nahtlose Integration von IO-Link fähigen Geräten in die Automatisierungsplattform ermöglicht und eine effiziente Kommunikation zwischen den Geräten gewährleistet.

Die Verbindungselemente können jeweils elektrische Anschlüsse wie Steckverbinder und/oder Klemmen und/oder Schraubverbindungen und/oder Lötstellen und/oder Kontakte, insbesondere Leiterbahnenkontakte, umfassen oder als solche ausgebildet sein. Dies hat den Vorteil, dass sie eine schnelle und sichere Verbindung ermöglichen, um eine effiziente Automatisierung der industriellen Anlagen zu gewährleisten.

Ferner kann im Rahmen der Erfindung vorgesehen sein, dass die Verbindungselemente beabstandet voneinander an einer Gehäuseseite des Grundkörpergehäuses angeordnet sind, um das daran angeschlossene weitere Funktionsmodul in einer vordefinierten Position an der Gehäuseseite aufzunehmen und zu halten. Dies kann den Vorteil haben, dass das weitere Funktionsmodul - ggf. auch ohne zusätzliche Befestigungselemente - sicher an der Gehäuseseite des Grundkörpergehäuses gehalten und/oder befestigt werden kann. Dadurch wird eine einfache und schnelle Montage des weiteren Funktionsmoduls ermöglicht. Es ist außerdem möglich, dass Befestigungselemente - als Teil der Verbindungselemente oder zusätzlich zu den Verbindungselementen - in Form von Gewindebolzen oder Schrauben vorgesehen sind, um eine zuverlässige und robuste lösbare Verbindung zwischen dem Grundkörpergehäuse und dem weiteren Funktionsmodul zu gewährleisten. Durch die Verwendung solcher mechanischer Befestigungselemente wie Gewindebolzen oder Schrauben kann eine hohe mechanische Stabilität der Verbindung erreicht werden.

Vorteilhafterweise kann bei der Erfindung vorgesehen sein, dass elektrische Leitungen, insbesondere in der Form von Leiterbahnen wenigstens einer Leiterplatte der Elektronikanordnung, im Grundkörpergehäuse angeordnet und mit der Verbindungsanordnung elektrisch verbunden sind. Dies kann es ermöglichen, den Hauptenergiefluss und/oder den Hilfsenergiefluss und/oder den Datenfluss bereitzustellen, insbesondere auch für jedes der weiteren Funktionsmodule (ggf. auch mittelbar durch das angeschlossene weitere Funktionsmodul). Damit kann die Automatisierungsplattform zur Automatisierung betrieben werden, bspw. durch eine Bereitstellung einer Motoransteuerung als eine der mehreren Funktionen. Dies kann den Vorteil haben, dass eine kompakte und platzsparende Bauweise der Automatisierungsplattform erreicht wird, da die elektrischen Leitungen innerhalb des Grundkörpergehäuses angeordnet sind und somit keine zusätzlichen Platzanforderungen entstehen. Die elektrischen Leitungen können dabei auch die (erste) Verbindungsanordnung mit einer zweiten Verbindungsanordnung des Funktionsmoduls elektrisch verbinden und somit den Hauptenergiefluss und/oder den Hilfsenergiefluss und/oder den Datenfluss von dem angeschlossenen weiteren Funktionsmodul an ein zweites angeschlossenes weiteres Funktionsmodul übermitteln.

Optional ist es denkbar, dass wenigstens eine erste der elektrischen Leitungen zur Bereitstellung des Hauptenergieflusses vorgesehen ist und/oder wenigstens eine zweite der elektrischen Leitungen zur Bereitstellung des Hilfsenergieflusses vorgesehen ist und/oder wenigstens eine oder mehrere dritte der elektrischen Leitungen zur Bereitstellung des Datenflusses vorgesehen sind. Dabei können die erste(n), die zweite(n) und/oder die dritte(n) elektrischen Leitungen in unterschiedlichen Kanälen des Grundkörpergehäuses angeordnet und/oder durch Trennwände getrennt und/oder auf unterschiedlichen Leiterplatten der Elektronikanordnung ausgebildet sein. Dies kann den Vorteil haben, dass die verschiedenen Leitungen getrennt voneinander verlegt werden können, um Interferenzen und Störungen zu vermeiden. Dadurch wird die Zuverlässigkeit und Stabilität des Systems erhöht. Es ist außerdem möglich, dass die Leitungen unterschiedliche Spannungen und Ströme führen, die durch die Trennung und die Verwendung von unterschiedlichen Leiterplatten besser gesteuert und überwacht werden können. Somit wird die Sicherheit des Systems erhöht und die Gefahr von Kurzschlüssen und Überlastungen reduziert.

Außerdem kann es im Rahmen der Erfindung von Vorteil sein, dass die Verbindungsanordnung dazu ausgebildet ist, den Hauptenergiefluss und/oder den Hilfsenergiefluss und/oder den Datenfluss zwischen dem Funktionsmodul und dem angeschlossenen weiteren Funktionsmodul bereitzustellen, um das angeschlossene weitere Funktionsmodul zur Bereitstellung einer weiteren der mehreren Funktionen zu betreiben, und insbesondere, um durch den Hilfsenergiefluss das angeschlossene weitere Funktionsmodul mit Energie für die Bereitstellung der Funktion zu versorgen. Mit anderen Worten kann der Hauptenergiefluss und/oder der Hilfsenergiefluss auch dazu dienen, wenigstens eines der weiteren Funktionsmodule mit Energie zu versorgen, und ggf. nicht nur ein elektrischen Gerät der Anlage. Auch ist es möglich, dass ein Datenaustausch zwischen den Funktionsmodulen über den Datenfluss stattfindet. Somit bildet die Verbindungsanordnung eine Basis für einen modularen Aufbau der Funktionsmodule zur Ausbildung einer flexibel einsetzbaren Automatisierungsplattform.

In einer weiteren Möglichkeit kann vorgesehen sein, dass zusätzlich zu der Verbindungsanordnung, die als eine erste Verbindungsanordnung den elektrischen Anschluss für das angeschlossene weitere Funktionsmodul bereitstellt, eine zweite Verbindungsanordnung vorgesehen ist, die ggf. ebenfalls am Grundkörpergehäuse angeordnet ist, um einen zweiten elektrischen Anschluss für ein zweites der mehreren weiteren Funktionsmodule bereitzustellen. Dabei kann die zweite Verbindungsanordnung ebenfalls Verbindungselemente umfassen. Auch die Verbindungselemente der zweiten Verbindungsanordnung können beabstandet voneinander an einer zweiten Gehäuseseite des Grundkörpergehäuses angeordnet sein. Die zweite Gehäuseseite kann der ersten Gehäuseseite gegenüberliegen. Mit anderen Worten können die erste und zweite Gehäuseseiten als gegenüberliegende Seiten - vorzugsweise Außenseiten - des Grundkörpergehäuses vorgesehen sein. Somit ist es möglich, dass das an der ersten Verbindungsanordnung angeschlossene (erste) weitere Funktionsmodul und das an der zweiten Verbindungsanordnung angeschlossene zweite (weitere) Funktionsmodul auf gegenüberliegenden Seiten des Grundkörpergehäuses aufgenommen und gehhalten werden. Wenn mehrere weitere derart konfigurierte Funktionsmodule mit erster und zweiter Verbindungsanordnung aneinander angeschlossen werden, kann auf diese Weise eine modulare Reihenschaltung der Funktionsmodule erzielt werden. Dies kann den Vorteil haben, dass die Gesamtfunktionalität der Automatisierungsplattform in einfacher Weise erweitert werden kann, indem zusätzliche Funktionsmodule hinzugefügt werden.

Die Funktionsmodule der Automatisierungsplattform können vorzugsweise entlang einer Achse in einer Reihenschaltung miteinander verbunden werden, welche der Anschluss- und vorzugsweise Steckrichtung der (ersten) Verbindungsanordnung und insbesondere auch der (zweiten) Verbindungsanordnung folgt bzw. parallel hierzu verläuft. Damit ist gemeint, dass die Automatisierungsplattform baulich einfach in einer festen Richtung erweitert werden kann, indem zusätzliche Funktionsmodule in Richtung der Achse aneinander verbunden werden. Auf eine separate Backplane, welche die Funktionsmodule miteinander verbindet und auf welche die Funktionsmodule gesteckt werden müssen, kann daher verzichtet werden. Die Backplane ist mit anderen Worten funktional in jedes der Funktionsmodule integriert. Dies hat den Vorteil, dass die Automatisierungsplattform platzsparend und anpassungsfähig bleibt, ohne dass eine umständliche Neukonfiguration notwendig ist.

Vorteilhafterweise kann im Rahmen der Erfindung vorgesehen sein, dass die Verbindungsanordnung, d. h. insbesondere als eine erste Verbindungsanordnung, und die zweite Verbindungsanordnung direkt mit wenigstens einer Leiterplatte der Elektronikanordnung verbunden sind, um den Hauptenergiefluss und/oder den Hilfsenergiefluss und/oder den Datenfluss zwischen dem an der ersten Verbindungsanordnung angeschlossenen ersten (weiteren) Funktionsmodul und dem an der zweiten Verbindungsanordnung angeschlossenen zweiten (weiteren) Funktionsmodul über die Verbindungsanordnungen und über die wenigstens eine Leiterplatte bereitzustellen. Mit anderen Worten kann das Funktionsmodul den Hauptenergiefluss und/oder den Hilfsenergiefluss und/oder den Datenfluss von der ersten Verbindungsanordnung zur zweiten Verbindungsanordnung durchreichen. Es ist auch möglich, dass das Funktionsmodul den Hauptenergiefluss und/oder den Hilfsenergiefluss und/oder den Datenfluss nicht nur durchreicht, sondern auch abzweigt, um ihn selbst zu nutzen (z. B. zur Energieversorgung oder zur Kommunikation).

Es kann von Vorteil sein, wenn im Rahmen der Erfindung das Hauptenergieverbindungselement dazu ausgebildet ist, den Hauptenergiefluss mit einer Wechselspannung bis zu 1000 Volt und/oder einer Gleichspannung bis zu 1500 Volt und/oder mit einer Wechselspannung im Bereich von 70 Volt bis 1000 Volt und/oder mit einer Gleichspannung im Bereich von 130 Volt bis 1500 Volt, und bevorzugt mit einer Wechselspannung von im Wesentlichen 400 Volt oder einer Gleichspannung im Bereich von 650 V bis 700 V, bereitzustellen, vorzugsweise, um über den Hauptenergiefluss wenigstens ein elektrisches Gerät der industriellen Anlage mit Energie zu versorgen, bevorzugt, um einen Motor zu betreiben. Dabei kann hierzu der Hauptenergiefluss über das angeschlossene weitere Funktionsmodul und/oder über weitere der Funktionsmodule für das elektrische Gerät, insbesondere den Motor, bereitgestellt werden.

Weiter ist es denkbar, dass das Hauptenergieverbindungselement dazu ausgebildet ist, den Hauptenergiefluss mit einer elektrischen Spannung bereitzustellen, welche mindestens doppelt oder dreimal oder viermal so hoch ist wie eine elektrische Spannung, mit der der Hilfsenergiefluss bereitgestellt wird.

Weiter ist es denkbar, dass das Hilfsenergieverbindungselement dazu ausgebildet ist, den Hilfsenergiefluss mit einer Wechselspannung bis zu 50 Volt und/oder einer Gleichspannung bis zu 120 Volt und/oder mit einer Wechselspannung im Bereich von 0,01 Volt bis 50 Volt und/oder mit einer Gleichspannung im Bereich von 0,01 Volt bis 120 Volt, und bevorzugt mit einer Gleichspannung von im Wesentlichen 24 V oder 48 V, bereitzustellen, vorzugsweise, um eine Energieversorgung für wenigstens eines der weiteren Funktionsmodule und/oder für eine Kommunikation mit wenigstens einem der elektrischen Geräte bereitzustellen, bevorzugt für einen Feldbus.

Weiter ist es denkbar, dass das Datenverbindungselement dazu ausgebildet ist, ein Daten- und vorzugsweise Feldbussignal zu übertragen, vorzugsweise zur Kommunikation mit wenigstens einem der elektrischen Geräte. Das Datenverbindungselement kann mehrere Kontakte, insbesondere Pins, aufweisen, welche elektrische Verbindungen zwischen den Funktionsmodulen zum Datenaustausch ermöglichen. Beispiele für die Kontakte sind Ground, VCC, Clock, Data, Reset, Enable, Interrupt, Address, Data Bus, Control Bus, Power, Ground, Read, Write, und dergleichen.

Beispielsweise kann es vorgesehen sein, dass die Verbindungsanordnung dazu ausgebildet ist, den Hauptenergiefluss und/oder den Hilfsenergiefluss und/oder den Datenfluss zwischen dem Funktionsmodul und dem (daran) angeschlossenen weiteren Funktionsmodul bereitzustellen, um wenigstens einem der weiteren Funktionsmodule (d. h. insbesondere auch einem weiteren als dem angeschlossenen weiteren Funktionsmodul) den Hauptenergiefluss bereitzustellen, damit über dieses weitere Funktionsmodul ein elektrisches Gerät der industriellen Anlage mit Energie versorgt wird, und um wenigstens einem anderen der weiteren Funktionsmodule den Hilfsenergie- und/oder Datenfluss bereitzustellen, damit über dieses andere weitere Funktionsmodul das oder ein weiteres elektrische Gerät auf Basis des Datenflusses angesteuert wird. Die Ansteuerung von Geräten wie Motoren auf Basis des Datenflusses ist z. B. bei Motorsteuerungen vorgesehen, wobei hierzu bspw. eine Drehzahl des Motors anhand eines Steuerungssignals eingestellt wird, welches über den Datenfluss übertragen wird.

In einer weiteren Möglichkeit kann vorgesehen sein, dass die Elektronikanordnung wenigstens eine Leiterplatte aufweist, die innerhalb des Grundkörpergehäuses angeordnet ist. Auf der Leiterplatte können mehrere Elektronikbauteile für die Bereitstellung der mindestens einen Funktion angeordnet sein. Weiter können auf der Leiterplatte mehrere elektrische Leiterbahnen vorgesehen sein, um den Hauptenergiefluss und/oder den Hilfsenergiefluss und/oder den Datenfluss bereitzustellen, vorzugsweise zwischen dem am Funktionsmodul angeschlossenen ersten Funktionsmodul an ein am Funktionsmodul angeschlossenes zweites Funktionsmodul.

Auf der Leiterplatte können ferner mehrere Elektronikbauteile vorgesehen/angeordnet sein, um die zumindest eine der mehreren Funktionen bereitzustellen, vorzugsweise eine Energieversorgungs- und/oder Steuerungsfunktion für wenigstens ein elektrisches Gerät der industriellen Anlage. Hierzu können ein oder mehrere Geräteanschlüsse für das wenigstens eine elektrische Gerät am Grundkörpergehäuses angeordnet und/oder mit der Leiterplatte elektrisch verbunden sein. Dies dient vorzugsweise dazu, um den Hauptenergiefluss und/oder den Hilfsenergiefluss und/oder den Datenfluss und/oder die Energieversorgungs- und/oder Steuerungsfunktion für das wenigstens eine elektrische Gerät über die Geräteanschlüsse bereitzustellen.

Ein weiterer Vorteil im Rahmen der Erfindung ist erzielbar, wenn die Verbindungsanordnung an einer Gehäuseanschlussfläche des Grundkörpergehäuses angeordnet ist. Weiter kann im Grundkörpergehäuse wenigstens eine Aufnahme für ein Befestigungselement vorgesehen sein, um das Funktionsmodul mit dem weiteren Funktionsmodul zu verbinden. Hierbei kann vorgesehen sein, dass die Aufnahme gegenüber der Gehäuseanschlussfläche geneigt ist.

Mit anderen Worten kann die Aufnahme schräg zur Gehäuseanschlussfläche angebracht sein, bspw. mit einem Winkel kleiner als 90 ° oder kleiner als 70 ° oder im Bereich von 10° bis 80° bezogen auf eine Längsachse der Aufnahme und der durch die Gehäuseanschlussfläche definierten Ebene.

Durch die beschriebene Befestigung, insbesondere durch eine schräge Verschraubung, können die Funktionsmodule zusammengezogen und miteinander verbunden werden. Jedes Grundkörpergehäuse verfügt optional zudem beidseitig über gerade Gewindebohrungen, um nach jedem Modul einen Deckel anzubringen, um das so entstandene System abzuschließen. Um die einzelnen Funktionsmodule miteinander zu verbinden, können als Befestigungselemente und Aufnahmen z. B. Stecker und Buchsen verwendet werden, welche am Ende durch die Deckel verschlossen werden.

Außerdem ist es von Vorteil, wenn die (erste und/oder zweite) Verbindungsanordnung an einer (jeweiligen ersten bzw. zweiten) Gehäuseanschlussfläche des Grundkörpergehäuses angeordnet ist. Dabei kann an der Gehäuseanschlussfläche wenigstens oder genau ein Dichtmittel angeordnet sein, insbesondere, um durch den Anschluss des weiteren Funktionsmoduls gepresst zu werden und den Anschluss auf diese Weise zuverlässig abzudichten. Auf diese Weise kann das Eindringen von Feuchtigkeit oder Schmutz in das Grundkörpergehäuse verhindert werden. Es ist außerdem möglich, dass das Dichtmittel aus einem elastischen Material besteht, um eine bessere Anpassung an die Gehäuseanschlussfläche zu gewährleisten. Dadurch kann eine höhere Dichtigkeit erreicht werden, was insbesondere bei Anwendungen in feuchten oder staubigen Umgebungen von Vorteil ist. Weiter ist es möglich, dass das Dichtmittel in Form von Dichtungsbändern oder Dichtungskordeln vorliegt. Diese können um die Anschlussfläche gelegt werden und sorgen durch ihre Form für eine zuverlässige Abdichtung. Alternativ kann das Dichtmittel auch in Form von Dichtungspasten oder -sprays vorliegen, die direkt auf die Anschlussfläche aufgetragen werden. Diese Form des Dichtmittels kann besonders einfach und schnell aufgetragen werden, jedoch ist hierbei der weitere Herstellungsschritt bei einem erfindungsgemäßen Verfahren denkbar, dass ein vollständiges Aushärten der Dichtungspaste oder des -sprays abgewartet wird, um eine zuverlässige Abdichtung zu gewährleisten.

Eine weitere mögliche Ausbildung des Dichtmittels ist eine Lamellendichtung, was den Vorteil haben kann, dass sie sich flexibel an die Anschlussfläche anpassen kann und somit auch bei Unebenheiten eine zuverlässige Abdichtung gewährleistet. Die Lamellendichtung kann aus einem elastischen Material wie beispielsweise Silikon bestehen und in Form von Streifen oder Bändern hergestellt sein. Diese können dann um die Anschlussfläche gelegt und durch den Anschluss des weiteren Funktionsmoduls zusammengepresst werden, wodurch eine zuverlässige Abdichtung entsteht.

Eine weitere Möglichkeit zur Verbesserung der Dichtigkeit kann darin bestehen, dass die Verbindungsanordnung mit einem zusätzlichen Sicherungselement versehen wird, das die Verbindung zwischen den beiden Funktionsmodulen zusätzlich stabilisiert und somit ein Lösen oder Verschieben der Verbindung verhindert. Hierbei kann es sich beispielsweise um eine Schraube oder eine Klemme handeln, die die beiden Funktionsmodule fest miteinander verbindet.

Ferner kann im Rahmen der Erfindung vorgesehen sein, dass wenigstens ein Befestigungsmittel am Grundkörpergehäuse vorgesehen ist, um einen Deckel mit den Funktionsmodulen zu befestigen, welcher die modular miteinander verbundenen Funktionsmodule verschließt. Dies kann den Vorteil haben, dass die Funktionsmodule sicher und geschützt vor äußeren Einflüssen aufbewahrt werden können. Darüber hinaus kann durch eine lösbare Befestigung des Deckels am Grundkörpergehäuse eine einfache Handhabung und ein schneller Austausch der Funktionsmodule gewährleistet werden. Es ist außerdem möglich, dass die Befestigungsmittel eine formschlüssige Verbindung zwischen Deckel und Grundkörpergehäuse ermöglichen, um eine zusätzliche Stabilität und Sicherheit zu gewährleisten.

Vorteilhafterweise kann bei der Erfindung vorgesehen sein, dass auf einer Unterseite des Grundkörpergehäuses ein Kühlkörper vorgesehen ist, um eine Wärmeabfuhr für die Elektronikanordnung bereitzustellen. Dies kann den Vorteil haben, dass eine Überhitzung der Elektronikanordnung vermieden wird, was die Lebensdauer der Bauteile erhöht und die Zuverlässigkeit der gesamten Anordnung verbessert. Es ist außerdem möglich, dass der Kühlkörper aus einem Material mit hoher Wärmeleitfähigkeit besteht, um eine effektive Wärmeabfuhr zu gewährleisten. Der Kühlkörper ist bspw. hergestellt aus Aluminium oder Kupfer und durch Befestigungsmitteln wie Schrauben am Grundkörpergehäuse befestigt. Durch die Verwendung eines solchen Kühlkörpers kann die Anordnung auch bei hohen Temperaturen zuverlässig betrieben werden. Der Kühlkörper kann dabei auf der dem Deckel gegenüberliegenden Unterseite des Funktionsmoduls bzw. Grundkörpergehäuses angeordnet sein. Dagegen kann die Verbindungsanordnung, und ggf. auch die zweite Verbindungsanordnung, an den Seitenflächen des Grundkörpergehäuses vorgesehen sein.

Ebenfalls Gegenstand der Erfindung ist eine Automatisierungsplattform, aufweisend ein erfindungsgemäßes Funktionsmodul sowie die weiteren Funktionsmodule. Damit bringt die erfindungsgemäße Automatisierungsplattform die gleichen Vorteile mit sich, wie sie ausführlich mit Bezug auf ein erfindungsgemäßes Funktionsmodul beschrieben worden sind Es können z. B. mindestens oder genau ein oder zwei oder drei oder vier oder bis zu 10 weitere Funktionsmodule vorgesehen und ggf. in Reihe miteinander verbunden sein.

Auch ist es optional denkbar, dass das Funktionsmodul die Verbindungsanordnung und insbesondere eine zweite Verbindungsanordnung aufweist, und die jeweiligen weiteren Funktionsmodule ebenfalls mindestens eine (oder zwei gegenüberliegende) weitere Verbindungsanordnung(en) aufweisen, um die Funktionsmodule in Reihe aneinander zu stecken und um den Hauptenergiefluss und/oder den Hilfsenergiefluss und/oder den Datenfluss zwischen den Funktionsmodulen bereitzustellen. Dies ermöglicht eine kompakte Anordnung und Erweiterung der Automatisierungsplattform.

Die Automatisierungsplattform kann für eine Vielzahl von Automatisierungsaufgaben und diesbezügliche Funktionen zur Automatisierung eingesetzt werden. Bspw. können Funktionsmodule vorgesehen sein für eine Einspeisung eines Haupt- und/oder Hilfsenergieflusses als eine erste Funktion, und/oder für eine Einspeisung eines Hilfsenergie- und/oder Datenflusses (z. B. als eine Feldbus- und/oder Netzwerk- und/oder Internet-Schnittstelle) als eine weitere Funktion, und/oder für eine Motoransteuerung als eine weitere Funktion, und/oder für eine Datenverarbeitung als eine weitere Funktion, z. B. durch ein Industrie PC-Funktionsmodul, und/oder für eine Stromversorgung für elektrische Geräte der industriellen Anlage als eine weitere Funktion, und/oder für eine Energiepufferung (d. h. eine Zwischenspeicherung von Energie) zur Energieversorgung wenigstens eines der Funktionsmodule, wie des Industrie-PC-Funktionsmoduls, als eine weitere Funktion, und/oder für eine Bereitstellung einer IO-Link Kommunikation für die elektrischen Geräte als eine weitere Funktion, z. B. durch ein IO-Link Master-Funktionsmodul, und/oder für eine Feldbus-Anbindung durch eine Feldbus-Schnittstelle wie ein Ethernet-Switch als eine weitere Funktion und/oder für eine Cloud-Anbindung durch eine Internet-Schnittstelle als eine weitere Funktion und/oder für eine Sensor-Anbindung als eine weitere Funktion, und/oder für eine Erstellung eines digitalen Zwillings, bspw. zur Projektierung, als eine weitere Funktion, und/oder für eine Überwachung der Automatisierung und/oder der industriellen Anlage mittels einer App, insbesondere durch eine Funkschnittstelle, als eine weitere Funktion, und/oder für eine Predictive Maintenance -Anwendung, z. B. durch eine entsprechende Datenverarbeitungseinheit, als eine weitere Funktion.

Es kann wenigstens eines der Funktionsmodule der Automatisierungsplattform zur Cloud-Anbindung ausgebildet sein. Hierzu kann das Funktionsmodul eine Internet-Schnittstelle aufweisen, welche hardwareseitig als eine Ethernet-Schnittstelle und/oder softwareseitig als eine REST-API oder eine SOAP-Schnittstelle ausgeführt sein kann. Damit kann die dezentrale Automatisierung der industriellen Anlage dadurch unterstützt werden, dass die Daten der Anlage, insbesondere in Echtzeit, in die Cloud übertragen werden. Dies ermöglicht bspw. eine Fernüberwachung und -steuerung der Anlage, sowie eine Analyse und Auswertung der Daten. Zudem können Updates und Wartungen der Anlage aus der Ferne durchgeführt werden, was zu einer höheren Effizienz und Verfügbarkeit der Anlage führt.

Weiter kann wenigstens eines der Funktionsmodule der Automatisierungsplattform zur Sensor-Anbindung vorgesehen sein. Das Funktionsmodul kann mit anderen Worten dazu dienen, Sensoren der industriellen Anlage in eine automatisierte Produktionslinie zu integrieren. Hierbei kann das Funktionsmodul zur Sensor-Anbindung eine Sensorschnittstelle wie eine IO-Link-Schnittstelle aufweisen, um die Kommunikation zwischen dem Sensor und einem Steuerungssystem zu ermöglichen.

Weiter kann wenigstens eines der Funktionsmodule der Automatisierungsplattform für eine Erstellung eines digitalen Zwillings, bspw. zur Projektierung, vorgesehen sein. Hierzu kann das Funktionsmodul durch eine entsprechende Softwarelösung ergänzt werden. Durch die Verwendung von Sensordaten und anderen Echtzeitdaten, ggf. empfangen aus der Cloud, kann der digitale Zwilling eine exakte Kopie des realen Objekts bzw. der industriellen Anlage darstellen. Dies ermöglicht es, verschiedene Szenarien und Simulationen durchzuführen, um die Leistung und das Verhalten des realen Objekts bzw. der Anlage vorherzusagen und zu optimieren.

Weiter kann wenigstens eines der Funktionsmodule der Automatisierungsplattform für eine Überwachung der Automatisierung und/oder der industriellen Anlage mittels einer App vorgesehen sein. Hierzu kann das Funktionsmodul mit einer Schnittstelle zur drahtlosen Kommunikation ausgestattet werden. Die App kann dann auf einem mobilen Endgerät installiert und genutzt werden. Durch die App können die relevanten Daten der Automatisierung und/oder der industriellen Anlage in Echtzeit überwacht und analysiert werden. Dies ermöglicht es dem Nutzer, schnell auf mögliche Probleme zu reagieren und die Anlage effektiver zu betreiben.

Weiter kann wenigstens eines der Funktionsmodule der Automatisierungsplattform für eine Predictive Maintenance-Anwendung, z. B. durch eine entsprechende Datenverarbeitungseinheit, vorgesehen sein. Mit anderen Worten ist es möglich, dass das Funktionsmodul durch eine Datenverarbeitungseinheit für Predictive Maintenance-Anwendung ergänzt wird. Hierzu kann das Funktionsmodul mit wenigstens einer Schnittstelle für Sensoren ausgestattet werden, die Daten sammeln und an die Datenverarbeitungseinheit weiterleiten. Dies ermöglicht es, dass die Datenverarbeitungseinheit die Daten analysiert und Vorhersagen über potenzielle Ausfälle oder Wartungsbedarf treffen kann.

Weiter kann wenigstens eines der Funktionsmodule eine Kommunikations- und vorzugsweise Funkschnittstelle aufweisen, z. B. eine W-LAN und/oder 5G und/oder Bluetooth Schnittstelle.

Die Funktionsmodule können neben ihren jeweiligen Funktionen gleichzeitig eine elektrische Verbindungsplattform bereitstellen, bei welcher Verbindungsleitungen vorgesehen sind, um einen Hauptenergie- (wie 400V/16A), Hilfsenergie (24V/48V) und Datenfluss bereitzustellen. Die Verbindung der Funktionsmodule ermöglicht es, bestehende Lösungen anzupassen und zusätzliche Funktionsmodule zu ergänzen. Es kann bspw. eines der Funktionsmodule der Automatisierungsplattform als ein Safety Controller ausgebildet sein, welcher eine Einspeisung des Hauptenergieflusses über einen Hauptschalter ermöglicht. Weiter kann eines der Funktionsmodule der Automatisierungsplattform als ein Netzteil für die Elektronik ausgeführt sein, welches hierzu den Hilfsenergiefluss mit bspw. 24 V bereitstellt. Ebenfalls kann als Hilfsenergie eine Stromversorgung für eine Antriebstechnik vorgesehen sein, z. B. mit 48 V. Zur Versorgung der Antriebe können MQ15 DC-Anschlüsse und ein Hybrid-Kabel genutzt werden, welches auch die Aktorik und Notfallabschaltung über ein STO-Signal versorgt.

Weiter kann wenigstens eines der Funktionsmodule der Automatisierungsplattform als ein Industrie-PC ausgebildet sein. Der Industrie-PC, auch als Controller bezeichnet, umfasst ggf. eine Multicore-CPU. Die Kommunikation erfolgt bspw. über verschiedene Kanäle wie W-LAN, 5G und Bluetooth sowie OPC-UA (Open Platform Communications Unified Architecture) und MQTT (Message Queuing Telemetry Transport). Zur Pufferung des Industrie-PCs kann ein 8 Ah Li-Ion Akku zur Verfügung stehen, um schnelle Start-up Zeiten aus dem Sleep-Modus zu gewährleisten. Des Weiteren kann ein IO-Link Master z. B. mit 8-facher Anschlussmöglichkeit sowie ein Ethercat Safety mit IO und 16/4 Anschluss vorhanden sein. Optional ist ferner die Ausbildung eines der Funktionsmodule als 8-fach Single Pair Ethernet Switch.

Es ist möglich, dass die Automatisierungsplattform ohne separate Backplane nur aus den Funktionsmodulen ausgebildet ist. Daher können die Funktionsmodule über die Verbindungselemente selbst die Anschlüsse aufweisen, um miteinander mechanisch und elektrisch verbunden zu werden. Mit anderen Worten können die Funktionsmodule zum modularen Aufbau der Automatisierungsplattform selbst die Verbindungsleitungen und Anschlüsse aufweisen, die üblicherweise auf einer separaten Backplane vorgesehen sind. Damit lässt sich eine Automatisierungsplattform bereitstellen, die sich bedarfsgenau zusammenstellen lässt und die Automatisierungskomponenten dezentral ins Feld bringt. Die Automatisierungsplattform kann auf diese Weise zur dezentralen Automatisierung mit einem modular aufgebauten System dienen und zumindest teilweise einen Schaltschrank ersetzen, wie er üblicherweise für zentrale Topologien einer elektrotechnischen Anlage, insbesondere Automatisierungsanlage, eingesetzt wird. Das elektrische Verbindungskonzept der Automatisierungsplattform bietet insbesondere die Möglichkeit, für die unterschiedlichen Spannungen und Datenverbindungen separate Leitungen vorzusehen. Eine Feldbusverbindung eignet sich beispielsweise für die Datenübertragung. Die Integration von dezentralen Servoantrieben ermöglicht ein zuverlässiges Spannungs-, Signal- und Datenmanagement direkt im Feld. Dadurch können sämtliche Automatisierungsfunktionen komplett dezentral und ohne Schaltschrank realisiert werden. Die Automatisierungsplattform kann somit als dezentrales Automatisierungssystem mit einem modular aufgebauten System dienen und zumindest teilweise einen Schaltschrank ersetzen. Eine aufwändige Installation entfällt, Rüstzeiten und Fehlerquellen werden eliminiert und die Wartung kann optional durch Predictive Maintenance an die Produktionszyklen angepasst werden.

Die Automatisierungsplattform ist dabei insbesondere ein System ohne separate Backplane und besteht vorzugsweise nur aus den Funktionsmodulen.

Ebenfalls Gegenstand der Erfindung ist ein Verfahren zur Bereitstellung einer dezentralen Automatisierungsplattform, bei welcher ein Funktionsmodul mit mehreren weiteren Funktionsmodulen modular verbunden wird, insbesondere, um modular mehrere Funktionen zur Automatisierung einer industriellen Anlage bereitzustellen.

Das erfindungsgemäße Verfahren kann gemäß einem ersten Verfahrensschritt aufweisen: Bereitstellen einer Elektronikanordnung für die Ausführung zumindest einer der mehreren Funktionen.

Weiter kann das erfindungsgemäße Verfahren als weiteren Verfahrensschritt aufweisen: Bereitstellen eines Grundkörpers mit einem Grundkörpergehäuse, in welchem die Elektronikanordnung angeordnet wird.

Weiter kann das erfindungsgemäße Verfahren als weiteren Verfahrensschritt aufweisen: Bereitstellen einer Verbindungsanordnung, die am Grundkörpergehäuse und/oder einem damit verbundenen Gehäuse angeordnet wird und/oder mit der Elektronikanordnung elektrisch verbunden wird, um einen elektrischen Anschluss für eines der mehreren weiteren Funktionsmodule bereitzustellen. Dabei kann die Verbindungsanordnung einen Hauptenergiefluss und/oder einen Hilfsenergiefluss und/oder einen Datenfluss zwischen dem Funktionsmodul und dem angeschlossenen weiteren Funktionsmodul bereitstellen, um die Automatisierungsplattform zur Automatisierung der industriellen Anlage zu betreiben. Hierzu kann die Verbindungsanordnung ferner die folgenden Verbindungselemente umfassen:
- ein Hauptenergieverbindungselement zur Bereitstellung des Hauptenergieflusses für das daran angeschlossene weitere Funktionsmodul,
- ein Hilfsenergieverbindungselement zur Bereitstellung des Hilfsenergieflusses, mit geringerer elektrischer Spannung als der Hauptenergiefluss, für das daran angeschlossene weitere Funktionsmodul,
- ein Datenverbindungselement zur Bereitstellung des Datenflusses für das daran angeschlossene weitere Funktionsmodul.

Damit bringt das erfindungsgemäße Verfahren die gleichen Vorteile mit sich, wie sie ausführlich mit Bezug auf ein erfindungsgemäßes Funktionsmodul beschrieben worden sind.

Die Automatisierungsplattform kann dadurch dezentral ausgebildet sein, dass sie mit einer oder mehreren weiteren dezentralen Automatisierungsplattformen Automatisierungsfunktionen für die Anlage bereitstellt. Dabei können die eine oder mehreren weiteren dezentralen Automatisierungsplattformen jeweils ebenfalls als erfindungsgemäße Automatisierungsplattform ausgebildet sein. Die Automatisierungsplattformen können entsprechend Teilautomatisierungsfunktionen bereitstellen, welche komplementär die Automatisierung der Anlage ermöglichen. Die Teilautomatisierungsfunktionen umfassen bspw. eine Steuerung und/oder Regelung von Größen wie Druck, Durchfluss oder Temperatur und/oder eine Überwachung von Prozessparametern und/oder eine Steuerung und/oder Auswertung von Aktoren und Sensoren.

Es kann vorgesehen sein, dass die einzelnen unterschiedlichen Teilautomatisierungsfunktionen durch dafür ausgebildete Funktionsmodule bereitgestellt werden. Auf diese Weise können Teilautomatisierungsfunktionen bei einer Automatisierungsplattform modular ergänzt und kombiniert werden. Die Funktionsmodule umfassen bspw. ein Energieversorgungsmodul, wie ein Netzteil, und/oder ein Feldbusmodul und/oder ein Sicherheitsmodul zur Überwachung und Absicherung von Prozessen und/oder ein Motorsteuerungsmodul und/oder einen Industrie-PC, welcher Steuerungsaufgaben übernehmen kann. Zusätzlich können auch Pneumatik- und/oder Hydraulikmodule als Funktionsmodule vorgesehen sein, um bspw. Bewegungen und Kräfte zu steuern. Diese Module können beispielsweise dazu ausgebildet sein, Zylinder, Ventile und/oder Pumpen anzusteuern Auch können diese Funktionsmodule Zylinder, Ventile und/oder Pumpen umfassen. Durch die Kombination von elektronischen und pneumatischen/hydraulischen Elementen können komplexe und präzise Steuerungsaufgaben in verschiedenen Anwendungsbereichen, wie der Automatisierungstechnik, realisiert werden.

Ferner ist es denkbar, dass die Automatisierungsplattformen mit einer übergeordneten Steuerung (Zentralsteuerung) verbunden sind, bspw. über ein Feldbussystem. Allerdings können die dezentralen Automatisierungsplattformen eine Funktion eines zentralen Schaltschrankes ggf. zumindest teilweise ersetzen. Hierzu können die Automatisierungsplattform im Feld der Anlage angeordnet sein, z. B. in der Nähe von Aktoren und Sensoren. Dies kann den Vorteil haben, dass eine hohe Flexibilität und Skalierbarkeit der Automatisierung erreicht wird, da weitere dezentrale Automatisierungsplattformen in einfacher Weise hinzugefügt werden können, um zusätzliche Automatisierungsfunktionen bereitzustellen. Es ist außerdem möglich, dass durch die dezentrale Ausbildung der Automatisierungsplattformen eine einfachere Wartung, eine höhere Robustheit und Ausfallsicherheit der Automatisierung erreicht wird, da Ausfälle einzelner Komponenten durch andere dezentrale Automatisierungsplattformen kompensiert werden können. Dadurch wird eine hohe Verfügbarkeit der Automatisierung gewährleistet.

Ebenfalls Gegenstand der Erfindung kann optional ein System für eine industrielle Anlage und/oder eine industrielle Anlage sein, welche(s) zumindest zwei oder zumindest vier oder zumindest sechs Automatisierungsplattformen aufweist. Die jeweilige Automatisierungsplattform kann hierbei dadurch dezentral ausgebildet sein, dass sie mit der oder den jeweils anderen Automatisierungsplattformen gemeinsam Automatisierungsfunktionen und vorzugsweise Teilautomatisierungsfunktionen für die industrielle Anlage bereitstellt. Dabei können die jeweiligen Automatisierungsplattformen als erfindungsgemäße Automatisierungsplattform ausgebildet sein.

Die Automatisierungsplattformen können optional jeweils Teilautomatisierungsfunktionen bereitstellen, welche komplementär (also in Bezug auf die gemeinsame Bereitstellung der Teilautomatisierungsfunktionen durch die sämtlichen Automatisierungsplattformen) die Automatisierung der Anlage ermöglichen. Die Teilautomatisierungsfunktionen umfassen bspw. eine Steuerung und/oder Regelung von Größen wie Druck, Durchfluss oder Temperatur und/oder eine Überwachung von Prozessparametern und/oder eine Steuerung und/oder Auswertung von Aktoren und Sensoren.

Ebenfalls unter Schutz gestellt sein kann eine Anlage mit den dezentralen Automatisierungsplattformen.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine perspektivische Ansicht eines Funktionsmoduls gemäß Ausführungsvarianten der Erfindung.
- Fig. 2: eine Seitenansicht eines Funktionsmoduls gemäß Ausführungsvarianten der Erfindung.
- Fig. 3: eine Schnittansicht einer Automatisierungsplattform gemäß Ausführungsvarianten der Erfindung.
- Fig. 4: ein schematischer Verbindungsplan einer Automatisierungsplattform gemäß Ausführungsvarianten der Erfindung.
- Fig. 5: schematisch ein Verfahren gemäß Ausführungsvarianten der Erfindung.

In den nachfolgenden Figuren werden für die gleichen technischen Merkmale auch von unterschiedlichen Ausführungsbeispielen die identischen Bezugszeichen verwendet.

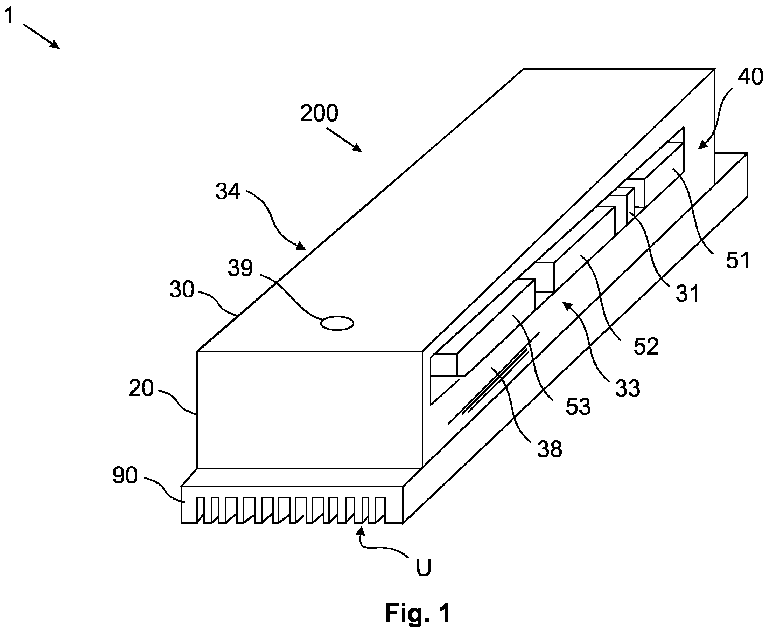

Fig. 1 veranschaulicht gemäß Ausführungsbeispielen der Erfindung ein Funktionsmodul 200 zur Ausbildung einer dezentralen Automatisierungsplattform 1, bei welcher das Funktionsmodul 200 mit mehreren weiteren Funktionsmodulen 201 modular verbunden werden kann. Auf diese Weise können modular mehrere Funktionen zur Automatisierung einer industriellen Anlage erweitert werden.

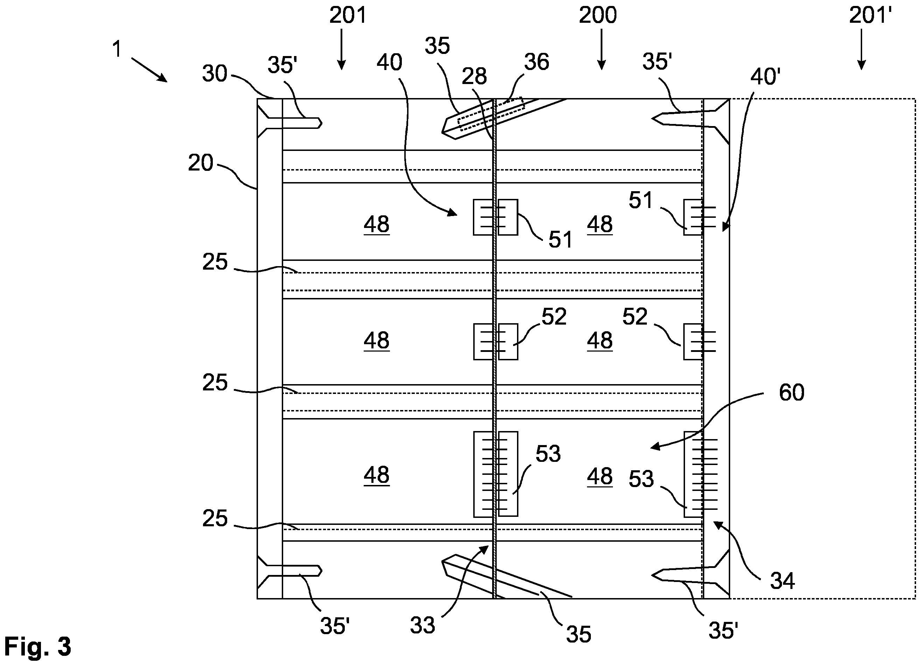

Das Funktionsmodul 200 kann als ein tragbares Bauteil ausgebildet sein, welches zur Montage manuell mit weiteren Funktionsmodulen 201 verbunden wird. Es ist daher ein Grundkörper 20 vorgesehen, der ein Grundkörpergehäuse 30 aufweist. Das Grundkörpergehäuse kann im Wesentlich rechteckförmig ausgebildet sein, sodass ein einfaches Aneinanderstecken der mehreren Funktionsmodule 200,201 platzsparend und einfach handhabbar möglich ist. Zur sicheren Montage kann das Grundkörpergehäuse 30 einen elektrisch isolierenden Kunststoff aufweisen. Im Grundkörper kann eine in Fig. 3 veranschaulichte Elektronikanordnung 60 angeordnet sein. Die Elektronikanordnung 60 dient insbesondere zur Bereitstellung zumindest einer der mehreren Funktionen. Je nach Funktionsmodul kann sich diese Funktion und damit auch die Elektronikanordnung 60 unterscheiden. Bspw. können Funktionsmodule 200, 201 vorgesehen sein für:
- eine Einspeisung eines Haupt- und/oder Hilfsenergieflusses als eine erste Funktion, und/oder
- eine Einspeisung eines Hilfs- und/oder Datenflusses (z. B. als eine Feldbus-Schnittstelle) als eine weitere Funktion, und/oder
- eine Motoransteuerung als eine weitere Funktion, und/oder
- eine Datenverarbeitung als eine weitere Funktion, z. B. durch ein Industrie PC-Funktionsmodul, und/oder
- eine Stromversorgung für elektrische Geräte der industriellen Anlage als eine weitere Funktion, und/oder
- eine Energiepufferung (d. h. eine Zwischenspeicherung von Energie) zur Energieversorgung wenigstens eines der Funktionsmodule, wie des Industrie-PC-Funktionsmoduls, als eine weitere Funktion, und/oder
- eine Bereitstellung einer IO-Link Kommunikation für die elektrischen Geräte als eine weitere Funktion, z. B. durch ein IO-Link Master-Funktionsmodul, und/oder
- eine Feldbus-Schnittstelle wie ein Ethernet-Switch als eine weitere Funktion.

Es ist erkennbar, dass sich durch eine Auswahl von mehreren dieser Funktionsmodule 200,201 modular und flexibel eine Automatisierungsplattform 1 mit vielseitiger Funktionalität aufbauen und einfach auf spezifische Automatisierungsaufgaben der industriellen Anlage anpassen lässt.

Um einen Zusammenbau der Automatisierungsplattform 1 zu ermöglichen, ist es gemäß Ausführungsvarianten der Erfindung vorgesehen, dass die Funktionsmodule 200, 201 miteinander verbunden und vorzugsweise zusammengesteckt werden. Hierzu ist eine in Fig. 1 dargestellte Verbindungsanordnung 40 vorgesehen, die am Grundkörpergehäuse 30 angeordnet ist, um einen elektrischen Anschluss für eines der mehreren weiteren Funktionsmodule 201 bereitzustellen. Über den elektrischen Anschluss können bspw. der Hauptenergie- und/oder Hilfsenergie- und/oder Datenenergiefluss an das daran angeschlossene weitere Funktionsmodule 201 elektrisch übertragen werden. Mit anderen Worten kann die Verbindungsanordnung 40 dazu ausgebildet sein, einen Hauptenergiefluss, einen Hilfsenergiefluss und einen Datenfluss zwischen dem Funktionsmodul 200 und dem angeschlossenen weiteren Funktionsmodul 201 bereitzustellen, um die Automatisierungsplattform 1 zur Automatisierung der industriellen Anlage zu betreiben.

Die elektrischen Spannungen, die an der Verbindungsanordnung 40 bereitgestellt werden, um den Hauptenergie-, Hilfsenergie- und/oder Datenfluss zu ermöglichen, müssen nicht zwingend vom angeschlossenen Funktionsmodul 201 auch genutzt werden. Ein Industrie-PC benötigt beispielsweise nicht zwangsläufig den Hauptenergiefluss. Es ist jedoch von Vorteil, wenn das angeschlossene Funktionsmodul 201 dennoch den Hauptenergie-, Hilfsenergie- und/oder Datenfluss weiterleitet, um diese den anderen Funktionsmodulen 201 zur Verfügung zu stellen. Damit kann eine modulare Erweiterung der Automatisierungsplattform 1 gewährleistet werden.

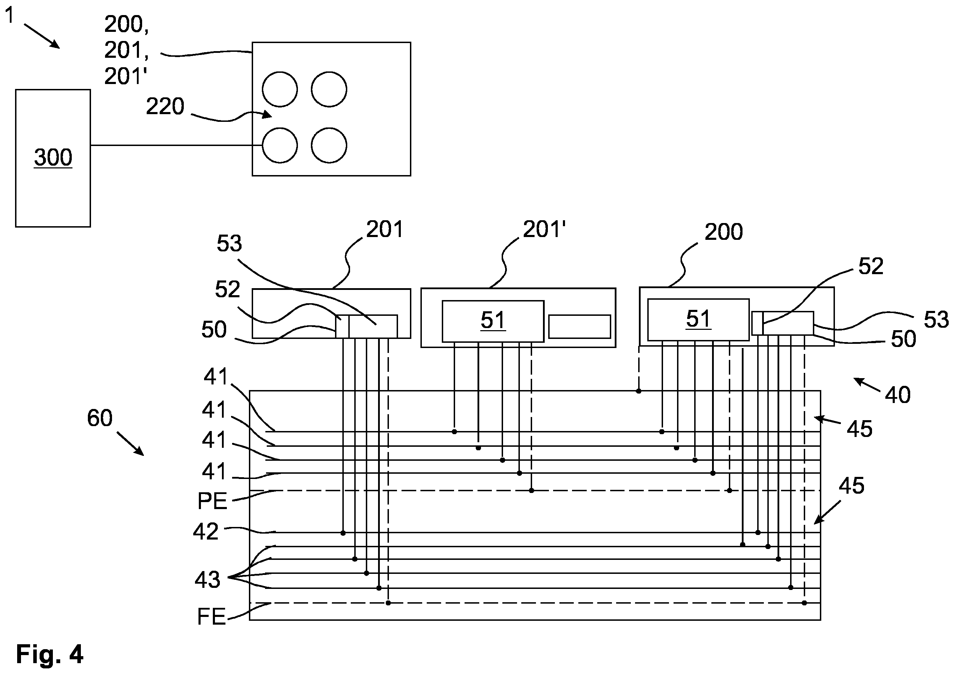

Im Einzelnen kann die Verbindungsanordnung 40 die folgenden in den Fig. 1-4 veranschaulichten Verbindungselemente 50 umfassen: ein Hauptenergieverbindungselement 51 zur Bereitstellung des Hauptenergieflusses für das daran angeschlossene weitere Funktionsmodul 201, ein Hilfsenergieverbindungselement 52 zur Bereitstellung des Hilfsenergieflusses, mit geringerer elektrischer Spannung als der Hauptenergiefluss, für das daran angeschlossene weitere Funktionsmodul 201, sowie ein Datenverbindungselement 53 zur Bereitstellung des Datenflusses für das daran angeschlossene weitere Funktionsmodul 201. Eine mögliche elektrische Verbindungskonfiguration dieser Verbindungselemente 50 ist in Fig. 4 in einem schematischen Schaltbild gezeigt. Darin ist auch erkennbar, dass nicht alle Funktionsmodule 200,201 der Automatisierungsplattform 1 jedes dieser Verbindungselemente 51-53 aufweisen muss. Allerdings ist es von Vorteil, wenn diejenigen Funktionsmodule 200,201, an denen zwei Funktionsmodule 200,201 angeschlossen wird, zur Weiterleitung des Hauptenergie-, Hilfsenergie- und Datenflusses auch alle Verbindungselemente 51-53 aufweisen - um eine reibungslose Weiterleitung des Hauptenergie-, Hilfsenergie- und Datenflusses in dieser Kaskade zu gewährleisten.

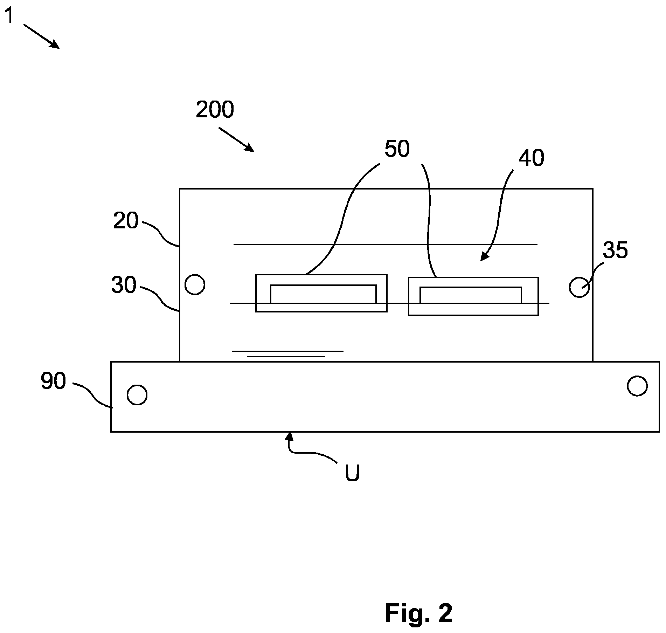

In Fig. 1 und 2 ist erkennbar, dass die Verbindungselemente 50 beabstandet voneinander an der Gehäuseseite 33 des Grundkörpergehäuses 30 angeordnet sein können, um das daran angeschlossene weitere Funktionsmodul 201 in einer vordefinierten Position an der Gehäuseseite 33 aufzunehmen und zu halten. Zusätzlich zu der Verbindungsanordnung 40, die als eine erste Verbindungsanordnung 40 den elektrischen Anschluss für das angeschlossene weitere Funktionsmodul 201 bereitstellt, kann eine in Fig. 3 schematisch gezeigte zweite Verbindungsanordnung 40' vorgesehen sein, die am Grundkörpergehäuse 30 angeordnet ist. Die zweite Verbindungsanordnung 40' kann einen zweiten elektrischen Anschluss für ein (nicht mit weiteren Einzelheiten gezeigtes, aber ggf. zum Funktionsmodul 201 oder 200 hinsichtlich der Verbindungsanordnung 40 baugleiches) zweites 201' der mehreren weiteren Funktionsmodule 201 bereitstellen. Dabei kann die zweite Verbindungsanordnung 40' baugleich zur ersten Verbindungsanordnung 40 ebenfalls Verbindungselemente 50 umfassen. Entsprechend können auch die Verbindungselemente 50 der zweiten Verbindungsanordnung 40' beabstandet voneinander angeordnet sein, allerdings an einer zweiten Gehäuseseite 34 des Grundkörpergehäuses 30. Vorteilhaft ist es, wenn die zweite Gehäuseseite 34 der ersten Gehäuseseite 33 gegenüberliegt, um das an der ersten Verbindungsanordnung 40 angeschlossene weitere erste Funktionsmodul 201 und das an der zweiten Verbindungsanordnung 40' angeschlossene zweite Funktionsmodul 201' auf gegenüberliegenden Seiten des Grundkörpergehäuses 30 aufzunehmen und zu halten.

Innerhalb des Grundkörpergehäuses 30 kann die Weiterleitung durch elektrische Leitungen 45 ermöglicht werden. Die elektrischen Leitungen 45 sind bspw. in der Form von Leiterbahnen 45 wenigstens einer Leiterplatte 48 der Elektronikanordnung 60 vorgesehen (vgl. Fig. 3, wobei die Leitungen 45 z. B. als Leiterbahnen zwischen den gleichartigen Verbindungselementen 51 bzw. 52 bzw. 53 der ersten Gehäuseseite 33 und der zweiten Gehäuseseite 34 verlaufen können). Die Leitungen 45 können im Grundkörpergehäuse 30 angeordnet und mit der Verbindungsanordnung 40 elektrisch verbunden sein, um den Hauptenergiefluss und/oder den Hilfsenergiefluss und/oder den Datenfluss bereitzustellen. Die Verbindungsanordnung 40 und die zweite Verbindungsanordnung 40' können direkt mit wenigstens einer Leiterplatte 48 der Elektronikanordnung 60 verbunden sind, um den Hauptenergiefluss, den Hilfsenergiefluss und den Datenfluss zwischen dem an der ersten Verbindungsanordnung 40 angeschlossenen ersten Funktionsmodul 201 und dem an der zweiten Verbindungsanordnung 40' angeschlossenen zweiten Funktionsmodul 201' über die Verbindungsanordnungen und über die wenigstens eine Leiterplatte 48 bereitzustellen.

Die elektrischen Leitungen 45 können gemäß Figur 3 und 4 wie folgt bereitgestellt werden: Wenigstens eine erste Leitung 41 dient der Hauptenergieversorgung, wenigstens eine zweite Leitung 42 dient der Hilfsenergieversorgung und mindestens eine dritte Leitung 43 dient der Datenübertragung. Diese Leitungen 41,42,43 sind gemäß Ausführungsbeispielen der Erfindung in verschiedenen Kanälen 25 des Grundkörpergehäuses 30 angeordnet (vgl. Fig. 3), insbesondere auf verschiedenen Leiterplatten 48 der Elektronikanordnung 60 ausgeführt und/oder durch Trennwände 31 getrennt (siehe Fig. 1).

Das in Fig. 3 gezeigte Hauptenergieverbindungselement 51 kann dazu ausgebildet sein, den Hauptenergiefluss bereitzustellen, um über den Hauptenergiefluss wenigstens ein in Fig. 4 gezeigtes elektrisches Gerät 300 der industriellen Anlage mit Energie zu versorgen. Bspw. kann ein Motor betrieben werden, wobei hierzu der Hauptenergiefluss über das angeschlossene weitere Funktionsmodul 201 und/oder über weitere der Funktionsmodule 201' für das elektrische Gerät 300 bzw. den Motor bereitgestellt wird.

Das Hilfsenergieverbindungselement 52 kann dazu ausgebildet sein, den Hilfsenergiefluss bereitzustellen, um eine Energieversorgung für wenigstens eines der weiteren Funktionsmodule 201 und/oder für eine Kommunikation mit wenigstens einem der elektrischen Geräte 300 bereitzustellen, bevorzugt für einen Feldbus. Weiter kann das Datenverbindungselement 53 dazu ausgebildet sein, ein Daten- und vorzugsweise Feldbussignal zu übertragen, vorzugsweise zur Kommunikation mit wenigstens einem der elektrischen Geräte 300.

Die in Fig. 3 schematisch gezeigte Elektronikanordnung 60 kann zumindest eine der mehreren Funktionen bereitzustellen, vorzugsweise eine Energieversorgungs- und/oder Steuerungsfunktion für wenigstens ein elektrisches Gerät 300 der industriellen Anlage. Hierzu können auch in Fig. 4 dargestellte ein oder mehrere Geräteanschlüsse 220 für das wenigstens eine elektrische Gerät 300 am Grundkörpergehäuses 30 angeordnet und/oder mit der Leiterplatte 48 elektrisch verbunden sein, vorzugsweise, um den Hauptenergiefluss und/oder den Hilfsenergiefluss und/oder den Datenfluss und/oder die Energieversorgungs- und/oder Steuerungsfunktion für das wenigstens eine elektrische Gerät 300 über die Geräteanschlüsse 220 bereitzustellen. Solche Geräteanschlüsse 220 können auch an den weiteren Funktionsmodulen 201,201' optional vorgesehen sein.

In Fig. 3 wird ferner eine mechanische Befestigungslösung gemäß Ausführungsvarianten der Erfindung verdeutlicht. Dabei kann im Grundkörpergehäuse 30 wenigstens eine Aufnahme 35 für ein Befestigungselement 36 vorgesehen ist, um das Funktionsmodul 200 mit dem weiteren Funktionsmodul 201 zu verbinden. Optional können auch weitere Aufnahmen 35' zu diesem Zweck vorgesehen sein. Es ist erkennbar, dass die Aufnahme 35 geneigt sein kann. Bspw. kann sich die Aufnahme 35 gegenüber einer in Fig. 1 verdeutlichten Gehäuseanschlussfläche 38 nicht senkrecht in das Grundkörpergehäuse 30 erstrecken, sondern gegenüber der Gehäuseanschlussfläche 38 geneigt sein, also einen Winkel ungleich 90 Grad aufweisen.

Weiter ist in Fig. 3 schematisch dargestellt, dass an der Gehäuseanschlussfläche 38 wenigstens oder genau ein Dichtmittel 28 vorgesehen ist, um durch den Anschluss des weiteren Funktionsmoduls 201 gepresst zu werden und den Anschluss abzudichten. Dies kann den Vorteil haben, dass das Eindringen von Feuchtigkeit und Staub in das Gehäuse des Funktionsmoduls verhindert wird. Mögliche konkrete Ausbildungen des Dichtmittels 28 können eine Lamellendichtung, eine Silikon-Dichtmasse, ein Dichtband oder eine vorgefertigte Dichtung sein. Hinsichtlich der Geometrie des Dichtmittels 28 ist eine flache Schicht oder eine ringförmige Dichtung oder eine im Wesentlichen rechteckig geformte Dichtung denkbar.

Gemäß Fig. 1 kann wenigstens ein Befestigungsmittel 39 am Grundkörpergehäuse 30 vorgesehen ist, um einen nicht explizit dargestellten Deckel mit den Funktionsmodulen 200,201 zu befestigen, welcher die modular miteinander verbundenen Funktionsmodule 200,201 verschließt. Weiter kann auf einer Unterseite U des Grundkörpergehäuses 30 ein Kühlkörper 90 vorgesehen ist, um eine Wärmeabfuhr für die Elektronikanordnung 60 bereitzustellen. Der Kühlkörper 90 weist im gezeigten Beispiel mehrere Rippen auf, die zur besseren Wärmeableitung ausgebildet sind. Der Kühlkörper 90 ist beispielsweise aus Aluminium hergestellt.

Ebenfalls zeigen die Fig. 1 bis 4 zumindest Teile einer Automatisierungsplattform 10 aufweisend ein Funktionsmodul 200 nach Ausführungsvarianten der Erfindung sowie die weiteren Funktionsmodule 201.

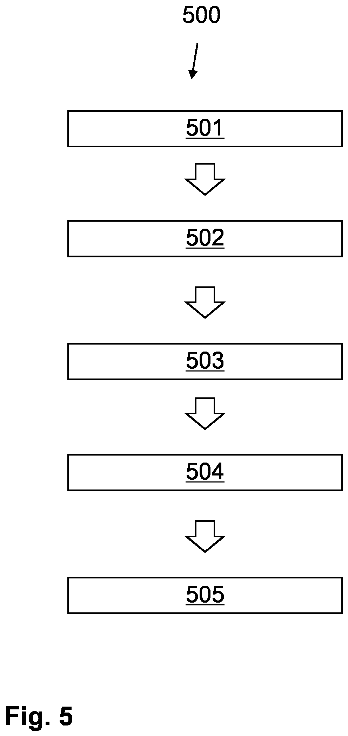

In Fig. 5 ist ein Verfahren 500 zur Bereitstellung einer dezentralen Automatisierungsplattform 1 gemäß Ausführungsbeispielen der Erfindung gezeigt. Dabei können die Verfahrensschritte 501-105 für jedes der Funktionsmodule 200,201,201' der Automatisierungsplattform 1 vorgesehen sein:
Gemäß einem ersten Verfahrensschritt 501 erfolgt ein Bereitstellen einer Elektronikanordnung 60 für die Ausführung zumindest einer der mehreren Funktionen. Ferner erfolgt gemäß einem zweiten Verfahrensschritt 502 ein Bereitstellen eines Grundkörpers 20 mit einem Grundkörpergehäuse 30, in welchem die Elektronikanordnung 60 angeordnet wird. Gemäß einem dritten Verfahrensschritt 503 erfolgt ein Bereitstellen einer Verbindungsanordnung 40, die am Grundkörpergehäuse 30 angeordnet wird, um einen elektrischen Anschluss für eines der mehreren weiteren Funktionsmodule 201 bereitzustellen. Dabei kann die Verbindungsanordnung 40 einen Hauptenergiefluss, einen Hilfsenergiefluss und einen Datenfluss zwischen dem Funktionsmodul 200 und dem angeschlossenen weiteren Funktionsmodul 201 bereitstellen, um die Automatisierungsplattform 1 zur Automatisierung der industriellen Anlage zu betreiben. Gemäß einem vierten Verfahrensschritt 504 können für die Verbindungsanordnung 40 mehrere Verbindungselemente 50 bereitgestellt werden, umfassend ein Hauptenergieverbindungselement 51, ein Hilfsenergieverbindungselement 52 und ein Datenverbindungselement 53. Gemäß einem fünften Verfahrensschritt 505 kann die Automatisierungsplattform 1 schließlich dadurch bereitgestellt werden, dass mehrere Funktionsmodule 200,201,201' miteinander verbunden werden.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 1: Automatisierungsplattform

- 20: Grundkörper
- 25: Kanäle
- 28: Dichtmittel

- 30: Grundkörpergehäuse
- 31: Trennwand
- 33: (erste) Gehäuseseite
- 34: zweite Gehäuseseite
- 35: Aufnahme
- 36: Befestigungselement
- 38: Gehäuseanschlussfläche
- 39: Befestigungsmittel

- 40: Verbindungsanordnung
- 41: Hauptenergieleitungen
- 42: Hilfsenergieleitungen
- 43: Datenleitungen
- 45: Leitungen
- 48: Leiterplatte

- 50: Verbindungselemente
- 51: Hauptenergieverbindungselement
- 52: Hilfsenergieverbindungselement
- 53: Datenverbindungselement

- 60: Elektronikanordnung

- 90: Kühlkörper

- 200: Funktionsmodule
- 201: weitere Funktionsmodule

- 220: Geräteanschlüsse

- 300: elektrische Geräte

- 35': weitere Aufnahme
- 40': weitere Verbindungsanordnung

- 500: Verfahren

- 201': zweite Funktionsmodul
- U: Unterseite

## Patentansprüche

1. Funktionsmodul (200) zur Ausbildung einer dezentralen Automatisierungsplattform (1), bei welcher das Funktionsmodul (200) mit mehreren weiteren Funktionsmodulen (201) modular verbunden ist, um modular erweiterbar mehrere Funktionen zur Automatisierung einer industriellen Anlage bereitzustellen, aufweisend:
- eine Elektronikanordnung (60) für die Bereitstellung zumindest einer der mehreren Funktionen,
- einen Grundkörper (20) mit einem Grundkörpergehäuse (30), in welchem die Elektronikanordnung (60) angeordnet ist,
- eine Verbindungsanordnung (40), die am Grundkörpergehäuse (30) angeordnet und/oder mit der Elektronikanordnung (60) elektrisch verbunden ist, um einen elektrischen Anschluss für eines der mehreren weiteren Funktionsmodule (201) bereitzustellen,
wobei die Verbindungsanordnung (40) dazu ausgebildet ist, einen Hauptenergiefluss, einen Hilfsenergiefluss und einen Datenfluss zwischen dem Funktionsmodul (200) und dem angeschlossenen weiteren Funktionsmodul (201) bereitzustellen, um die Automatisierungsplattform (1) zur Automatisierung der industriellen Anlage zu betreiben, wobei die Verbindungsanordnung (40) hierzu die folgenden Verbindungselemente (50) umfasst:
- ein Hauptenergieverbindungselement (51) zur Bereitstellung des Hauptenergieflusses für das daran angeschlossene weitere Funktionsmodul (201),
- ein Hilfsenergieverbindungselement (52) zur Bereitstellung des Hilfsenergieflusses, mit geringerer elektrischer Spannung als der Hauptenergiefluss, für das daran angeschlossene weitere Funktionsmodul (201),
- ein Datenverbindungselement (53) zur Bereitstellung des Datenflusses für das daran angeschlossene weitere Funktionsmodul (201).

2. Funktionsmodul (200) nach Anspruch 1,
**dadurch gekennzeichnet,**
**dass** die Verbindungselemente (50) beabstandet voneinander an einer Gehäuseseite (33) des Grundkörpergehäuses (30) angeordnet sind, um das daran angeschlossene weitere Funktionsmodul (201) in einer vordefinierten Position an der Gehäuseseite (33) aufzunehmen und zu halten.

3. Funktionsmodul (200) nach einem der vorhergehenden Ansprüche,
**dadurch gekennzeichnet,**
**dass** elektrische Leitungen (45), insbesondere in der Form von Leiterbahnen (45) wenigstens einer Leiterplatte (48) der Elektronikanordnung (60), im Grundkörpergehäuse (30) angeordnet und mit der Verbindungsanordnung (40) elektrisch verbunden sind, um den Hauptenergiefluss und/oder den Hilfsenergiefluss und/oder den Datenfluss bereitzustellen, insbesondere, um den Hauptenergiefluss und/oder den Hilfsenergiefluss und/oder den Datenfluss für jedes der weiteren Funktionsmodule (201) bereitzustellen und hierdurch die Automatisierungsplattform (1) zur Automatisierung zu betreiben, insbesondere auch durch eine Bereitstellung einer Motoransteuerung als eine der mehreren Funktionen, wobei vorzugsweise vorgesehen ist,
**dass** wenigstens eine erste der elektrischen Leitungen (45) zur Bereitstellung des Hauptenergieflusses vorgesehen ist, wenigstens eine zweite der elektrischen Leitungen (45) zur Bereitstellung des Hilfsenergieflusses vorgesehen ist und wenigstens dritte der elektrischen Leitungen (45) zur Bereitstellung des Datenflusses vorgesehen sind, wobei die erste, die zweite und die dritten elektrischen Leitungen (45) in unterschiedlichen Kanälen (25) des Grundkörpergehäuses (30) angeordnet und/oder durch Trennwände (31) getrennt und/oder auf unterschiedlichen Leiterplatten (48) der Elektronikanordnung (60) ausgebildet sind.

4. Funktionsmodul (200) nach einem der vorhergehenden Ansprüche,
**dadurch gekennzeichnet,**
**dass** die Verbindungsanordnung (40) dazu ausgebildet ist, den Hauptenergiefluss, den Hilfsenergiefluss und den Datenfluss zwischen dem Funktionsmodul (200) und dem angeschlossenen weiteren Funktionsmodul (201) bereitzustellen, um das angeschlossene weitere Funktionsmodul (201) zur Bereitstellung einer weiteren der mehreren Funktionen zu betreiben, und insbesondere, um durch den Hilfsenergiefluss das angeschlossene weitere Funktionsmodul (201) mit Energie für die Bereitstellung der Funktion zu versorgen.

5. Funktionsmodul (200) nach einem der vorhergehenden Ansprüche,
**dadurch gekennzeichnet,**
**dass** zusätzlich zu der Verbindungsanordnung (40), die als eine erste Verbindungsanordnung (40) den elektrischen Anschluss für das angeschlossene weitere Funktionsmodul (201) bereitstellt, eine zweite Verbindungsanordnung (40') vorgesehen ist, die am Grundkörpergehäuse (30) angeordnet ist, um einen zweiten elektrischen Anschluss für ein zweites (201') der mehreren weiteren Funktionsmodule (201) bereitzustellen, wobei die zweite Verbindungsanordnung (40') ebenfalls Verbindungselemente (50) umfasst, wobei die Verbindungselemente (50) der zweiten Verbindungsanordnung (40') beabstandet voneinander an einer zweiten Gehäuseseite (34) des Grundkörpergehäuses (30) angeordnet sind, die der ersten Gehäuseseite (33) gegenüberliegt, um das an der ersten Verbindungsanordnung (40) angeschlossene weitere (erste) Funktionsmodul (201) und das an der zweiten Verbindungsanordnung (40') angeschlossene zweite Funktionsmodul (201') auf gegenüberliegenden Seiten des Grundkörpergehäuses (30) aufzunehmen und zu halten, wobei vorzugsweise vorgesehen ist,
**dass** die erste Verbindungsanordnung (40) und die zweite Verbindungsanordnung (40') direkt mit wenigstens einer Leiterplatte (48) der Elektronikanordnung (60) verbunden sind, um den Hauptenergiefluss, den Hilfsenergiefluss und den Datenfluss zwischen dem an der ersten Verbindungsanordnung (40) angeschlossenen ersten Funktionsmodul (201) und dem an der zweiten Verbindungsanordnung (40') angeschlossenen zweiten Funktionsmodul (201') über die Verbindungsanordnungen und über die wenigstens eine Leiterplatte (48) bereitzustellen.

6. Funktionsmodul (200) nach einem der vorhergehenden Ansprüche,
**dadurch gekennzeichnet,**
**dass** das Hauptenergieverbindungselement (51) dazu ausgebildet ist, den Hauptenergiefluss mit einer Wechselspannung bis zu 1000 Volt und/oder einer Gleichspannung bis zu 1500 Volt und/oder mit einer Wechselspannung im Bereich von 70 Volt bis 1000 Volt und/oder mit einer Gleichspannung im Bereich von 130 Volt bis 1500 Volt, und bevorzugt mit einer Wechselspannung von im Wesentlichen 400 Volt oder einer Gleichspannung im Bereich von 650 V bis 700 V, bereitzustellen, vorzugsweise, um über den Hauptenergiefluss wenigstens ein elektrisches Gerät (300) der industriellen Anlage mit Energie zu versorgen, vorzugsweise, um einen Motor zu betreiben, wobei vorzugsweise hierzu der Hauptenergiefluss über das angeschlossene weitere Funktionsmodul (201) und/oder über weitere der Funktionsmodule (201) für das elektrische Gerät (300), insbesondere den Motor, bereitgestellt wird,
und/oder dass das Hilfsenergieverbindungselement (52) dazu ausgebildet ist, den Hilfsenergiefluss mit einer Wechselspannung bis zu 50 Volt und/oder einer Gleichspannung bis zu 120 Volt und/oder mit einer Wechselspannung im Bereich von 0,01 Volt bis 50 Volt und/oder mit einer Gleichspannung im Bereich von 0,01 Volt bis 120 Volt, und bevorzugt mit einer Gleichspannung von im Wesentlichen 24 V oder 48 V, bereitzustellen, vorzugsweise, um eine Energieversorgung für wenigstens eines der weiteren Funktionsmodule (201) und/oder für eine Kommunikation mit wenigstens einem der elektrischen Geräte (300) bereitzustellen, bevorzugt für einen Feldbus, und/oder dass das Datenverbindungselement (53) dazu ausgebildet ist, ein Daten- und vorzugsweise Feldbussignal zu übertragen, vorzugsweise zur Kommunikation mit wenigstens einem der elektrischen Geräte (300).

7. Funktionsmodul (200) nach einem der vorhergehenden Ansprüche,
**dadurch gekennzeichnet,**
**dass** die Verbindungsanordnung (40) dazu ausgebildet ist, den Hauptenergiefluss, den Hilfsenergiefluss und den Datenfluss zwischen dem Funktionsmodul (200) und dem angeschlossenen weiteren Funktionsmodul (201) bereitzustellen, um wenigstens einem der weiteren Funktionsmodule (201) den Hauptenergiefluss bereitzustellen, damit über dieses weitere Funktionsmodul (201) ein elektrisches Gerät (300) der industriellen Anlage mit Energie versorgt wird, und um wenigstens einem anderen der weiteren Funktionsmodule (201) den Hilfsenergie- und/oder Datenfluss bereitzustellen, damit über dieses andere weitere Funktionsmodul (201) das oder ein weiteres elektrische Gerät (300) auf Basis des Datenflusses angesteuert wird.

8. Funktionsmodul (200) nach einem der vorhergehenden Ansprüche,
**dadurch gekennzeichnet,**
**dass** die Elektronikanordnung (60) wenigstens eine Leiterplatte (48) aufweist, die innerhalb des Grundkörpergehäuses (30) angeordnet ist, wobei auf der Leiterplatte (48) mehrere elektrische Leiterbahnen vorgesehen sind, um den Hauptenergiefluss und/oder den Hilfsenergiefluss und/oder den Datenfluss bereitzustellen, vorzugsweise zwischen dem am Funktionsmodul (200) angeschlossenen ersten Funktionsmodul (201) an ein am Funktionsmodul (200) angeschlossenes zweites Funktionsmodul (201), und wobei auf der Leiterplatte (48) mehrere Elektronikbauteile angeordnet sind, um die zumindest eine der mehreren Funktionen bereitzustellen, vorzugsweise eine Energieversorgungs- und/oder Steuerungsfunktion für wenigstens ein elektrisches Gerät (300) der industriellen Anlage, wobei hierzu ein oder mehrere Geräteanschlüsse (220) für das wenigstens eine elektrische Gerät (300) am Grundkörpergehäuses (30) angeordnet und/oder mit der Leiterplatte (48) elektrisch verbunden sind, vorzugsweise, um den Hauptenergiefluss und/oder den Hilfsenergiefluss und/oder den Datenfluss und/oder die Energieversorgungs- und/oder Steuerungsfunktion für das wenigstens eine elektrische Gerät (300) über die Geräteanschlüsse (220) bereitzustellen.

9. Funktionsmodul (200) nach einem der vorhergehenden Ansprüche,
**dadurch gekennzeichnet,**
**dass** die Verbindungsanordnung (40) an einer Gehäuseanschlussfläche (38) des Grundkörpergehäuses (30) angeordnet ist, wobei im Grundkörpergehäuse (30) wenigstens eine Aufnahme (35) für ein Befestigungselement (36) vorgesehen ist, um das Funktionsmodul (200) mit dem weiteren Funktionsmodul (201) zu verbinden, wobei die Aufnahme (35) gegenüber der Gehäuseanschlussfläche (38) geneigt ist.

10. Funktionsmodul (200) nach einem der vorhergehenden Ansprüche,
**dadurch gekennzeichnet,**
**dass** die Verbindungsanordnung (40) an einer Gehäuseanschlussfläche (38) des Grundkörpergehäuses (30) angeordnet ist, wobei an der Gehäuseanschlussfläche (38) wenigstens oder genau ein Dichtmittel (28) angeordnet ist, um durch den Anschluss des weiteren Funktionsmoduls (201) gepresst zu werden und den Anschluss abzudichten.

11. Funktionsmodul (200) nach einem der vorhergehenden Ansprüche,
**dadurch gekennzeichnet,**
**dass** wenigstens ein Befestigungsmittel (39) am Grundkörpergehäuse (30) vorgesehen ist, um einen Deckel mit den Funktionsmodulen (200,201) zu befestigen, welcher die modular miteinander verbundenen Funktionsmodule (200,201) verschließt.

12. Funktionsmodul (200) nach einem der vorhergehenden Ansprüche,
**dadurch gekennzeichnet,**
**dass** auf einer Unterseite (U) des Grundkörpergehäuses (30) ein Kühlkörper (90) vorgesehen ist, um eine Wärmeabfuhr für die Elektronikanordnung (60) bereitzustellen.

13. Automatisierungsplattform (1), aufweisend ein Funktionsmodul (200) nach einem der vorhergehenden Ansprüche sowie die weiteren Funktionsmodule (201).

14. Automatisierungsplattform (1) nach Anspruch 13,
**dadurch gekennzeichnet,**
**dass** das Funktionsmodul (200) die Verbindungsanordnung (40) und insbesondere eine zweite Verbindungsanordnung (40') aufweist, und die jeweiligen weiteren Funktionsmodule (201) ebenfalls mindestens eine weitere Verbindungsanordnung (40') aufweisen, um die Funktionsmodule (200,201) in Reihe aneinander zu stecken und um den Hauptenergiefluss, den Hilfsenergiefluss und den Datenfluss zwischen den Funktionsmodulen (200, 201) bereitzustellen.

15. Verfahren (500) zur Bereitstellung einer dezentralen Automatisierungsplattform (1), bei welcher ein Funktionsmodul (200) mit mehreren weiteren Funktionsmodulen (201) modular verbunden wird, um modular mehrere Funktionen zur Automatisierung einer industriellen Anlage bereitzustellen, wobei die nachfolgenden Schritte vorgesehen sind:
- Bereitstellen (101) einer Elektronikanordnung (60) für die Ausführung zumindest einer der mehreren Funktionen,
- Bereitstellen (102) eines Grundkörpers (20) mit einem Grundkörpergehäuse (30), in welchem die Elektronikanordnung (60) angeordnet wird,
- Bereitstellen (103) einer Verbindungsanordnung (40), die am Grundkörpergehäuse (30) angeordnet wird und/oder mit der Elektronikanordnung elektrisch verbunden wird, um einen elektrischen Anschluss für eines der mehreren weiteren Funktionsmodule (201) bereitzustellen,
wobei die Verbindungsanordnung (40) einen Hauptenergiefluss, einen Hilfsenergiefluss und einen Datenfluss zwischen dem Funktionsmodul (200) und dem angeschlossenen weiteren Funktionsmodul (201) bereitstellt, um die Automatisierungsplattform (1) zur Automatisierung der industriellen Anlage zu betreiben, wobei die Verbindungsanordnung (40) hierzu die folgenden Verbindungselemente (50) umfasst:
- ein Hauptenergieverbindungselement (51) zur Bereitstellung des Hauptenergieflusses für das daran angeschlossene weitere Funktionsmodul (201),
- ein Hilfsenergieverbindungselement (52) zur Bereitstellung des Hilfsenergieflusses, mit geringerer elektrischer Spannung als der Hauptenergiefluss, für das daran angeschlossene weitere Funktionsmodul (201),
- ein Datenverbindungselement (53) zur Bereitstellung des Datenflusses für das daran angeschlossene weitere Funktionsmodul (201).
